# EUROPEAN PATENT SPECIFICATION

(11) **EP 4 354 104 B1**
(45) Date of publication and mention of the grant of the patent: **19.02.2025**
(21) Application number: 22201328.6
(22) Date of filing: 13.10.2022
(51) Int. Cl.: G01K 1/143, G01K 1/14, H01L 23/34, H01L 23/00

(54) **ELECTRONIC DEVICE AND METHOD FOR PRODUCING AN ELECTRONIC DEVICE**
ELEKTRONISCHE VORRICHTUNG UND VERFAHREN ZUR HERSTELLUNG EINER ELEKTRONISCHEN VORRICHTUNG
DISPOSITIF ÉLECTRONIQUE ET PROCÉDÉ DE FABRICATION D'UN DISPOSITIF ÉLECTRONIQUE

(43) Date of publication of application: 17.04.2024
(73) Proprietor: Hitachi Energy Ltd, 8050 Zürich (CH)
(72) Inventor: SANTOLARIA, Lluis, 4600 Olten (CH); TRUESSEL, Dominik, 5620 Bremgarten (CH); EHRBAR, Roman, 8037 Zürich (CH)
(74) Representative: Epping - Hermann - Fischer

(56) References cited:
- WO-A1-2018/016162
- WO-A1-2021/151949
- JP-A- 2018 107 243

## Description

The present disclosure relates to an electronic device and to a method for producing an electronic device.

WO 2018/016162 A1 discloses a temperature sensor positioned on a flexible substrate and placed on a semiconductor element. JP 2018 107243 A discloses a temperature sensor which is pressed against a switch element with the help of a screw and a flexible plate.

WO 2021/151949 A1 discloses a power semiconductor module in which a contact temperature sensor is positioned in thermal contact with a metal clip. The contact temperature sensor is connected to pins of a circuit board, which press the sensor against the metal clip.

It is an object to provide an improved electronic device, for example an electronic device which can be produced easily and/or which is compact in design. Another object is to provide an improved method for producing such an electronic device.

Embodiments of the disclosure relate to an improved electronic device and an improved method for producing an electronic device.

First, the electronic device is specified. The electronic device described herein may be, for example, a power semiconductor module or an assembly comprising a power semiconductor module.

According to an embodiment, the electronic device comprises a sensor element for measuring a physical quantity in the electronic device and a contact element which is configured to be mechanically biased. Furthermore, the electronic device comprises a measurement surface at which the physical quantity is to be measured with the help of the sensor element. The sensor element is placed on the measurement surface. The contact element is electrically connected to the sensor element. The connection between the sensor element and the contact element is a dry connection. The contact element is mechanically biased in order to prevent loosening of the at least one dry connection.

The described electronic device can, on the one hand, improve the quality of the determination of a physical quantity during operation of the electronic device. On the other hand, the implementation of a sensor element even in an electronic device, for which originally no sensor element was planned, can be realized with a relatively small modification of the electronic device. This is due to the use of the biasable contact element. For example, the biased contact element presses two elements of the electronic device, between which a dry contact is formed, against each other so that the dry contact is reliably maintained. Thus, at least one connection can be realized without soldering, gluing, sintering or welding or other joining methods.

The sensor element is, for example, a transducer (measurand transducer) and as such the part of a measuring device that responds directly to a measurand. Thus, the sensor element may be the first element of a measuring chain. The sensor element is, for example, configured to detect a physical quantity, like temperature, humidity, pressure, acceleration etc., and, as a response to that, generates or manipulates an electric signal which can be read out via the contact element.

The contact element is at least partially electrically conductive. The contact element comprises a contact region which is a region distant from, particularly opposite to, the sensor element and at which the contact element can be electrically connected. The contact element provides an electrically conductive path from the sensor element to the contact region. In this way, it might be enabled to read-out the sensor element with the help of the contact element, particularly to receive electrical signals from the sensor element via the contact element and/or to supply electrical signals to the sensor element via the contact element. Thus, the contact element may also be used to supply the sensor element with voltage and/or current.

The contact element may be formed in one piece or may consist of several parts. For example, the contact element is made of metal or comprises metal. That the contact element is configured to be mechanically biased means that at least a portion/section of the contact element is elastic and deformable in order to bring the contact element from a relaxed state of the contact element into a biased state of the contact element. In the biased state, the contact element tends to automatically return into the relaxed state. The at least one elastic portion of contact element is, for example, reversibly deformable. The contact element may comprise one or more deformable, elastic portions/sections like springs. When bringing the contact element from the relaxed state into the biased state, the at least one elastic or deformable portion is compressed and/or bended and/or deflected, for example. Mechanically biased and mechanically stressed are used as synonyms.

The sensor element is, for example, arranged between the measurement surface and the contact element or at least a portion of the contact element, particularly in a vertical direction. A vertical direction is herein meant to be a direction perpendicular to a main extension plane of the electronic device or the measurement surface. A lateral direction is a direction parallel to the electronic device or the measurement surface.

The sensor element and the contact element may adjoin each other. Also the sensor element and the measurement surface may adjoin each other.

The sensor element is mechanically connected to the measurement surface and the contact element. Also a thermal contact may be established between the sensor element and the measurement surface. At least one of the (mechanical) connections of the sensor element to the contact element and to the measurement surface is a dry connection. A dry connection is a non-material-locking connection, i.e. no material-locking connection (bond) is formed between the two elements/partners being connected. A dry connection is, e.g., a pure force-fitting and/or form-fitting connection. A dry connection can be non-destructively loosened.

The connection between the sensor element and the contact element is also an electrical connection. Likewise, the connection between the sensor element and the measurement surface may be an electrical connection. An electrical contact between two elements which is established without a material-locking connection, i.e. by a dry connection, is herein called "dry electrical contact".

The contact element is mechanically biased, i.e. in the biased state. Particularly, the contact element is fixed in the electronic device such that a transition of the contact element into its relaxed state is prevented. Since, however, the biased contact element tends to automatically switch into the relaxed state, it creates a force in the electronic device. The force may be transferred to a further member of the electronic device, for example to the sensor element.

The mechanically biased contact element is arranged such that it prevents loosening of the at least one dry connection. This may mean that the force created by the biased contact elements presses the two elements/partners, between which a dry connection is formed, against each other. In this way, the dry connection is maintained.

For example, the force created by the biased contact element in the electronic device is at least 0.01 N or at least 0.1 N.

According to a further embodiment, the sensor element is a temperature sensor. For example, the sensor element is a temperature sensitive resistor, also called a "thermistor". The sensor element may be an NTC, PTC, a platinum resistor, like a PT100 or PT1000, or a thermocouple. Alternatively, the sensor element may be a humidity sensor, an acceleration sensor or a pressure sensor.

Indeed, there is strong customer interest for the temperature supervision of, for example, power semiconductor devices (herein also called "power semiconductor chips" or simply "chips") or power semiconductor modules during operation. The temperature supervision is typically used for protection against overheating of the chips, for example in situations of overcurrent, or for monitoring of the degradation state of the power semiconductor module with respect to the aging of, for example, joining connections, which in turn has an impact on the thermal resistance and consequently on the chip temperature.

According to at least one embodiment, the contact element comprises or is one of: a spring contact element or a press contact pin. A spring contact element has, for example, a meander-shaped region and/or a V-shaped region and/or a U-shaped region and/or a spring washer region and/or spring region which can be compressed in order to bring the contact element into the biased state. Additionally or alternatively, a spring contact element can have a cantilever shaped portion which can be bended in order to bring the spring contact element into the biased state. A spring contact element may be formed in one piece or may be formed of several parts.

A press contact pin comprises, for example, a main body, e.g. a barrel or tubular body/sleeve, a tip element, e.g. a plunger, and one or more springs, like spiral spring(s), which can be compressed in order to bring the contact element into the biased state. The tip element is movably mounted with respect to the main body and can be moved towards or further into the main body by compressing the spring. A press contact pin is, for example, an elongated element. The tip element of the press contact pin may be connected to or in contact with the sensor element.

The connection between the sensor element and the measurement surface is realized as a material-locking connection. The material-locking connection may be a soldered, sintered, glued or welded connection or realized by any other applicable joining method

Also the electrical connection between the sensor element and the contact element may be provided by the material-locking connection, e.g. exclusively by the material-locking connection. Accordingly, the connection between the sensor element and the contact element is a dry connection and the electrical contact between them may be a dry contact.

According to a further embodiment, the sensor element is externally electrically connectable via the contact element. For example, the electronic device comprises a terminal region which is exposed and/or freely accessible and which is electrically connected to the contact element and, thus, also to the sensor element. The terminal region may be a region of the contact element, e.g. the above-mentioned contact region. Alternatively, the terminal region may be a region of an auxiliary terminal structure to which the contact element is electrically connected.

According to a further embodiment, the terminal region for externally electrically connecting the sensor element via the contact element overlaps with the sensor element in at least one lateral direction. The terminal region and the sensor element may overlap in two perpendicular lateral directions. In other words, in top view of the electronic device, i.e. when viewed along a vertical direction, the terminal region at least partially covers the sensor element. In this case, the terminal region is, for example, part of the contact element. In this case, the terminal region is offset of the sensor element in vertical direction. "Offset" herein means, that there is no overlap but there is a gap between the two respective elements.

According to a further embodiment, the terminal region for externally electrically connecting the sensor element via the contact element is offset of the sensor element in at least one lateral direction, for example in two perpendicular lateral directions. In top view of the electronic device, the terminal region is offset of the sensor element. In vertical direction, the terminal region may also be offset of the sensor element or may overlap with the sensor element.

According to a further embodiment, the sensor element comprises a top electrode at a top side of the sensor element. Additionally, the sensor element may comprise a bottom electrode at a bottom side of the sensor element, wherein the bottom side is opposite to the top side.

The top electrode and the bottom electrode are, for example, metallic areas of the sensor element. They may be configured to electrically connect the sensor element for read-out and/or to supply current and/or voltage to the sensor element.

According to a further embodiment, the contact element is connected to the top electrode of the sensor element. The contact element and the top electrode may be in direct contact, i.e. adjoin each other. The electrical contact may be realized by the connection between the top electrode and the contact element. For example, a dry connection is formed between the contact element and the top electrode. Accordingly, the electrical contact between the sensor element and the contact element may be a dry electrical contact. Alternatively, a material-locking connection may be formed between the sensor element and the contact element.

According to a further embodiment, the measurement surface is connected to the bottom electrode of the sensor element. The measurement surface and the bottom electrode may be in direct contact, i.e. adjoin each other. An electrical contact may be established between the bottom electrode and the measurement surface. A material-locking connection may be formed between the measurement surface and the bottom electrode. Alternatively, a dry connection may be formed between them.

According to a further embodiment, the electronic device comprises a power semiconductor device. By way of example, the power semiconductor device is a switching device. The power semiconductor device may be an IGBT or a MOSFET or a HEMT or a diode or a thyristor. In this case, the electronic device is or comprises, for example, a power semiconductor module having one or more power semiconductor devices.

The power semiconductor module may comprise a substrate with a top metallization and, optionally, with a bottom metallization. The at least one power semiconductor device may be mounted on the top side of the substrate where the top metallization is located, e.g. it may be mounted on the top metallization. The substrate may be a DBC (direct bonded copper) substrate or a DBA (direct bonded aluminum) substrate or an AMB (active metal bracing) substrate with an isolating ceramic layer or an IMS (isolated metal substrate) with an isolating resin layer, for example.

Furthermore, the power semiconductor module may comprise terminals (main terminals and, optionally, auxiliary terminals) for external electrical connection. The terminals may be realized by terminal structures, which are, for example, sheet-like and/or of metal and/or formed in one piece. Other shapes of the terminals, like hollow cylinders with screwed threads, like nuts, are possible. Terminal regions of the terminal structures are exposed in order to enable external electrical contact. The terminal structures may be bonded to the top metallization or may be realized by the top metallization. Terminals can also directly connect chips, but also control electronics.

The power semiconductor module may further comprise a housing body. The housing body may be formed of an electrically isolating material, like a resin and/or gel. The power semiconductor device(s) may be embedded in the housing body. The terminal structures may be at least partially embedded in the housing body. The terminal regions of the terminal structures may project out of the housing body, e.g. at lateral sides thereof. The housing body may comprise a housing frame surrounding a cavity. The cavity may be filled with the gel.

Moreover, the power semiconductor module may comprise a baseplate. The baseplate is, for example, intended for cooling. The substrate may be mounted on the base plate, e.g. with the bottom metallization facing the baseplate. The baseplate may be made of metal, like Cu or Al or an alloy thereof, or of a composite material like aluminum silicon carbide or magnesium silicon carbide. The baseplate may comprise cooling structures like pin fins or ribs at a side facing away from the substrate.

Herein, a lateral direction is, for example, a direction parallel to the main extension plane of the substrate. The vertical direction is then a direction perpendicular to the main extension plane of the substrate.

According to a further embodiment, the sensor element is placed on the power semiconductor device.

According to a further embodiment, the sensor element is placed in a region next to the power semiconductor device. For example, the sensor element is placed on the top metallization of the substrate next to the power semiconductor device and/or between two adjacent power semiconductor devices. The top metallization may then form the measurement surface.

The placement of the sensor element on the power semiconductor device has some advantages over the placement of the sensor element on the substrate next to the power semiconductor device or even on a separate substrate of the electronic device next to the substrate on which the power semiconductor device is mounted. For example, the quality of the determination of the chip temperature improves with the reduced distance between the chip and the temperature sensor. Indeed, in this case, the true temperature of the chip can be derived more accurately from the sensor reading using a thermal model. Moreover, a time delay of the temperature change and the corresponding measurement caused by a large distance can be clearly reduced when the sensor element is placed directly on the chip.

A further advantage of placing the sensor element on the power semiconductor device is that, if more than one heat generating chip is mounted on the substrate, the sensor reading refers mainly to one chip and not to an average of the chips. When the sensor element is placed between the chips on the substrate, the measured temperature is possibly not referring to the temperature of the thermally most disadvantageous or most degraded chip. In the worst case, strong degradation of the joining connection under one chip or of the chip itself is not detected.

Further, when the sensor element is placed on the chip, it can be avoided that, due to a degraded die bond not conducting the heat, a too high temperature of the chip is not detected.

Also, the placement of the sensor element on the top metallization next to the power semiconductor device consumes space on the substrate surface, which reduces the available space for chips. This may also have a negative impact on the thermal resistance and consequently on the rated costs per ampere.

Moreover, many products were originally developed without integration of a sensor element. As a consequence, there may be no area on the substrate available for the placement of the sensor element. However, meanwhile, there is a strong trend in customer requests towards implementation of thermal sensors.

The electronic device may comprise several of the above specified pairs of a sensor element and a contact element. For example, several power semiconductor devices are each assigned such a pair, with the sensor element thereof mounted on the respective power semiconductor device. It is also possible that one or more sensor elements of one or more such pairs are mounted on the top metallization of one or more substrates next to or in between the power semiconductor device(s) and one or more sensor elements of one or more such pairs are mounted on one or more power semiconductor devices. For example, there may be one such pair per substrate.

According to a further embodiment, the measurement surface is formed by a top electrode of the power semiconductor device. The top electrode of the power semiconductor device may be, for example, a source/emitter electrode or a drain/collector electrode. The top electrode may be made of metal, like Cu or Al or corresponding alloy.

The sensor reading of the sensor element is, for example, between the contact element and an output terminal (e.g. AC terminal) of the electronic device. Alternatively, the sensor reading may be between the contact element and an input terminal (e.g. DC+ or DC- terminal) of the electronic device.

According to a further embodiment, the contact element is electrically and mechanically connected to an auxiliary terminal of the electronic device. The auxiliary terminal is, for example, formed by an auxiliary terminal structure of the electronic device. The auxiliary terminal structure is, for example, a sheet-like metal element or a nut or a hollow (metal) cylinder. The auxiliary terminal(s) is(are) different from the main or power terminals of the electronic device. The main terminals may be AC, DC- and DC+ terminals. Particularly, the auxiliary terminals are configured to carry less current than the main terminals. The auxiliary terminals may be partially embedded into the housing body of the electronic device. The auxiliary terminals may be terminals for control of the power semiconductor device, like for measurements/detection. They may be aux-emitter or aux-collector terminals or gate terminals or terminals connecting sensors.

According to a further embodiment, the contact element is electrically and mechanically connected to the auxiliary terminal by means of a threaded connection. Alternatively, other connections, like soldering, welding, crimping or gluing are possible. It is also possible that the contact element is formed in one piece with the auxiliary terminal.

The auxiliary terminal is, for example, a terminal of the electronic device which is externally electrically connectable. That is, a terminal region of the auxiliary terminal is exposed and freely accessible. For example, the terminal region of the auxiliary terminal is exposed and/or projects out of the housing body at the lateral side thereof. Alternatively, the auxiliary terminal may be exposed and/or project vertically out of the housing body at a top side thereof, e.g. when the auxiliary terminal is a nut, a vertical pin, or a hollow sleeve.

Besides connecting the contact element to an auxiliary terminal, other ways of fixing the contact element in the electronic device are conceivable. For example, the contact element may be assembled into the housing body and form-fittingly surrounded thereby. Alternatively, a nut (e.g. of metal) may be embedded into the housing body and the contact element may be screwed into the nut.

According to a further embodiment, a thermally conductive material is arranged between the measurement surface and the sensor element. The thermally conductive material may be a paste filled with particulates, e.g. electrically conductive particles. The thermally conductive material may be electrically conductive or electrically isolating. The paste is liquid and/or viscous. Alternatively, the thermally conductive material may be a heat conductive sheet (e.g. an elastic sheet).

According to a further embodiment, the electronic device comprises at least one, i.e. one or more, power semiconductor modules and a cooler for the power semiconductor module. The cooler may be a carrier for the power semiconductor modules. The cooler is, for example, configured to guide a cooling liquid therethrough. The cooler may comprise a cooling channel for the cooling liquid. The cooler may be made of metal, like copper or aluminum or corresponding alloy. The power semiconductor module may be mounted on the cooler with the bottom metallization and/or the baseplate facing the cooler.

According to a further embodiment, the measurement surface is formed by the cooler, e.g. by a top surface thereof. The sensor element may then be used to measure the temperature of the cooler.

According to a further embodiment, the measurement surface is formed by the surface of the baseplate. The sensor element may then be placed next to a substrate or between two neighbored substrates, which are mounted on the baseplate.

According to a further embodiment, at least one of the surfaces of the two elements between which the dry contact is formed is roughened, particularly in order to increase the contact surface. The roughened surface may imprint into the adjoining surface and may therefore increase in the contact surface. Additionally, in this way, a form-fitting connection may be established. Moreover, an undesired oxide layer may be destroyed in this way or impurities/contaminations on the adjoining surface may be penetrated.

According to a further embodiment, the roughened surface has an average roughness of at least 1 µm or at least 1.6 µm or at least 2 µm.

Next, the method for producing an electronic device is specified. The electronic device according to any of the embodiments described herein may be produced with the help of this method. Therefore, all features disclosed for the electronic device are also disclosed for the method and vice versa.

According to an embodiment, the method for producing an electronic device comprises a step of providing a sensor element, a step of providing a contact element configured to be mechanically biased and providing a member for an electronic device having a measurement surface at which a physical quantity of the electronic device is to be measured with the help of the sensor element. In further steps the sensor element is placed onto the measurement surface and the contact element is electrically connected to the sensor element. At least one of the connection between the contact element and the sensor element and the connection between the sensor element and the measurement surface is a dry connection. In a further step, the contact element is mechanically biased and at least a portion of the mechanically biased contact element is fixed with respect to the member so that the contact element remains in the mechanically biased state in order to prevent loosening of the at least one dry connection.

The method steps may be performed in the specified order. That is, after providing the different elements, the sensor element may first be placed on the measurement surface. Then, the contact element may be electrically connected to the sensor element. The connection between the sensor element and the measurement surface is, for example, a dry connection. Then the contact element may be biased and then fixed in this biased state. The contact element may also be fixed with respect to the member and may be biased afterwards.

Alternatively, however, it is also possible to first electrically connect the sensor element and the contact element, e.g. by a material-locking connection, and then to mount this composite, also referred to as sensor unit, to the member by placing the sensor element onto the measurement surface, then biasing the contact element and then fixing the contact element in order to maintain it in the biased state.

The member may be, for example, a power semiconductor device, a substrate or a top metallization of the substrate, a baseplate, or a cooler. Accordingly, the measurement surface may be a top electrode of the power semiconductor device or the top metallization of the substrate or a surface of the baseplate or a surface of the cooler.

According to a further embodiment, a material-locking connection is formed between the contact element and the sensor element. This material-locking connection may also provide the electrical connection between the sensor element and the contact element.

According to a further embodiment, a material-locking connection is formed between the sensor element and the measurement surface. This material-locking connection may also provide an electrical connection between the sensor element and the measurement surface.

According to a further embodiment, a portion of the contact element is fixed with respect to the member by means of a threaded connection.

Hereinafter, the electronic device, and the method for producing an electronic device will be explained in more detail with reference to the drawings on the basis of exemplary embodiments. The accompanying figures are included to provide a further understanding. In the figures, elements of the same structure and/or functionality may be referenced by the same reference signs. It is to be understood that the embodiments shown in the figures are illustrative representations and are not necessarily drawn to scale. In so far as elements or components correspond to one another in terms of their function in different figures, the description thereof is not repeated for each of the following figures. For the sake of clarity, elements might not appear with corresponding reference symbols in all figures.
Figures 1 to 4 show different positions in an exemplary embodiment of the method for producing an electronic device as well as an exemplary embodiment of the electronic device,
Figures 5 to 7 show different positions in a further exemplary embodiment of the method for producing an electronic device,
Figures 8 to 10 show different positions in a further exemplary embodiment of the method as well as a further exemplary embodiment of the electronic device,
Figures 11 to 13 show different positions in a further exemplary embodiment of the method as well as a further exemplary embodiment of the electronic device,
Figures 14 and 15 show different positions in a further exemplary embodiment of the method as well as a further exemplary embodiment of the electronic device,
Figures 16 and 17 show further exemplary embodiments of the electronic device,
Figures 18 to 20 show different positions in a further exemplary embodiment of the method as well as a further exemplary embodiment of the electronic device,
Figures 21 and 22 show further exemplary embodiments of the electronic device.

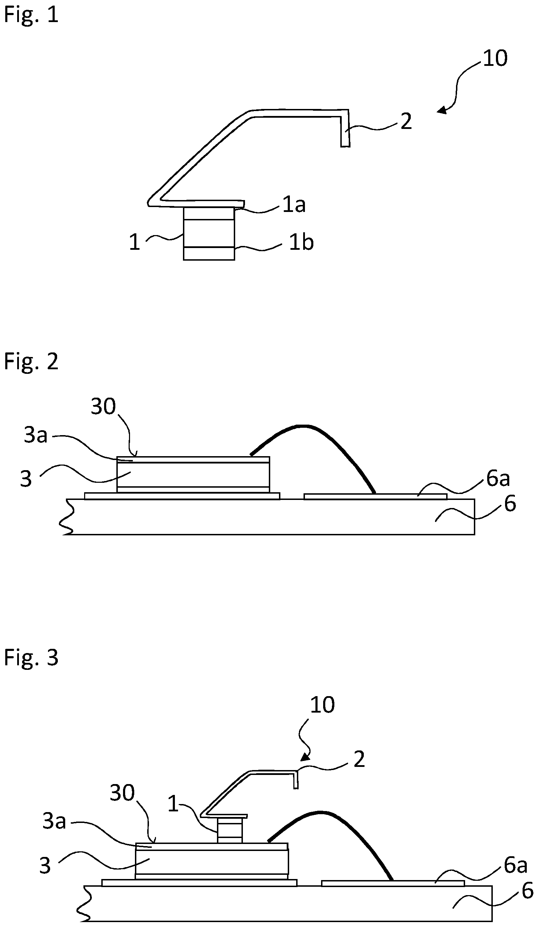

Figure 1 shows a position in which an exemplary embodiment of a sensor unit 10 for an electronic device 100 is provided. The sensor unit 10 comprises a contact element 2 and a sensor element 1. The contact element 2 is a spring contact element which can be mechanically biased by compressing or bending it. The contact element 2 is, for example, formed of metal, like Cu, Al or steel.

The sensor element 1 is, for example, a temperature sensor, like a thermistor. It may be an NTC, PTC or a platinum resistor (e.g. PT100 or PT1000) or a thermocouple. The sensor element 1 comprises a top electrode 1a and a bottom electrode 1b. Both electrodes 1a, 1b may be electrically conductive, particularly metallic. The electrodes 1a, 1b are arranged for reading-out the sensor element 1 but may also serve to supply current and/or voltage to the sensor element 1.

The contact element 2 is fixed to and electrically connected to the sensor element 1, namely to the top electrode 1a thereof. The mechanical and electrical connection between the contact element 2 and the sensor element 1 is, for example, realized by a material-locking connection, e.g. a soldered, sintered, welded or glued connection. Since the contact element 2 is electrically conductive, the sensor element 1 can be read-out with the help of the contact element 2.

Figure 2 shows a further position in which an assembly of different members 3, 6 for an electronic device is provided. One member is a substrate 6 having a top metallization 6a. The substrate 6 is, for example, a DBC substrate. A further member is a power semiconductor device 3, also referred to as power semiconductor chip, mounted on the top side of the substrate 6 and electrically connected thereto via a wire bond. The power semiconductor device 3 comprises a top electrode 3a which constitutes a measurement surface 30 and at which a physical quantity shall be measured with the help of the sensor element 1 of figure 1. By way of example, the power semiconductor device 3 is an IGBT or a power MOSFET with the top electrode 3a being a source or emitter electrode, respectively.

Figure 3 shows a position in which the sensor unit 10 of figure 1 with the composite of the sensor element 1 and the contact element 2 is placed on the power semiconductor device 3 so that the sensor element 1 adjoins the measurement surface 30. No additional connection material for forming a material-locking connection is used between the sensor element 1 and the measurement surface 30. Thus, there is a dry connection between the sensor element 1 and the measurement surface 30.

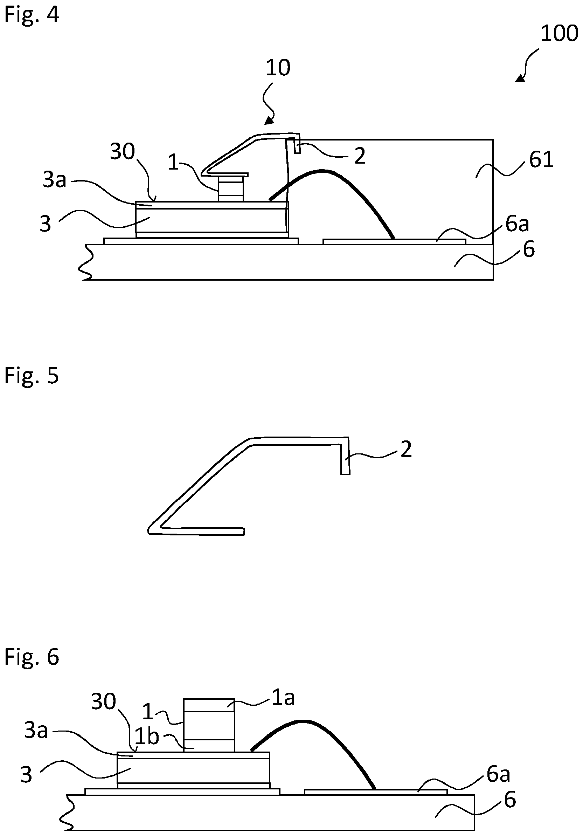

In the position of figure 4, an exemplary embodiment of an electronic device 100 is shown. The electronic device 100 is a power semiconductor module 100. In order to obtain this power semiconductor module 100 from the arrangement of figure 3, the contact element 2 has been compressed or bent and has thus been brought into its biased state. In this biased state, the contact element 2 exerts a force onto the sensor element 1 in the direction towards the measurement surface 30 and thereby presses the sensor element 1 against the measurement surface 30. In this way, the sensor element 1 is securely held on and connected to the measurement surface 30 due to the increased frictional force (dry connection) and a secure and also a reliable electrical connection (dry electrical contact) between the measurement surface 30 and the sensor element 1 is established.

The device of figure 4 may have been produced as follows: In the biased state of the contact element 2, a resin 61 has been applied on the substrate 6 and has encapsulated a part of the contact element 2. After drying the resin 61, the contact element 2 is fixed in its biased state so that the force exerted onto the sensor element 1 by the biased contact element 2 acts against loosening of the dry connection / dry contact. The resulting resin body 61 forms a housing frame 61 of the power semiconductor module 100. The cavity surrounded by the housing frame may be filled with a gel, for example.

Alternatively, the device of figure 4 may have been produced as follows: a pre-manufactured housing frame 61 could be mounted on the substrate 6 and the contact element 2 could then be clamped in the housing frame 61 so that it stays in the biased state. Alternatively, the contact element may be at least partly embedded into the housing frame as an integral part.

A portion of the contact element 2 at the top side of the power semiconductor module 100 is not covered by the resin body 61 and is exposed. This portion constitutes a terminal region of the contact element 2 for external electrical connection of the contact element 2. Thus, the sensor element 1 can, for example, be read-out via the contact element 2 and a DC- or AC terminal of the power semiconductor module 100.

A similar power semiconductor module 100 as described in connection with figure 4 can be obtained with another exemplary embodiment of the method, explained in connection with figures 5 to 7.

In the position of figure 5, a contact element 2 as explained in connection with figure 1 is provided. In contrast to figure 1, the contact element 2 is not yet connected to a sensor element 1.

In the position of figure 6, a sensor element 1, e.g. the same as described in connection with figure 1, is positioned on a measurement surface 30 realized by a power semiconductor device 3 mounted again on a substrate 6. The sensor element 1 is, for example, electrically connected and fixed to the power semiconductor device 3 by means of a material-locking connection, like a soldered, welded, glued or sintered connection.

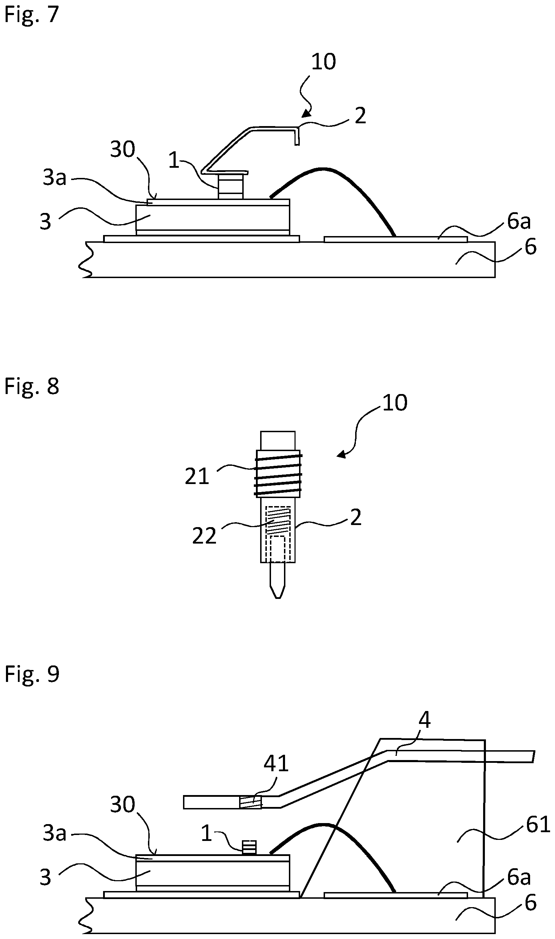

In the position of figure 7, the contact element 2 of figure 5 is placed on the top electrode 1a of the sensor element 1 and a dry electrical contact is formed between the contact element 2 and the sensor element 1.

The contact element 2 can now be biased by compressing or bending it and can be partially encapsulated with a resin 61 in order to fix the contact element 2 in its biased state (see explanation in connection with figure 4). The resulting power semiconductor module differs from the one of figure 4 in that the dry connection is then formed between the contact element 2 and the sensor element 1 and not between the sensor element 1 and the measurement surface 30. However, also here, the biased contact element creates a force in the power semiconductor module 100 acting against loosening of the dry connection.

Figure 8 shows a position in which a different contact element 2 is provided than in the previous exemplary embodiments. In this case, the contact element 2 is formed by a press contact pin. The press contact pin comprises a spring 22 for pressing a tip element or plunger, respectively, of the press contact pin away from a barrel or hollow sleeve of the press contact pin.

The contact element 2 further comprises means 21 for a threaded connection, namely an outer thread 21.

Figure 9 shows a position, in which an assembly of different members for an electronic device is provided. This assembly again comprises a substrate 6 and a power semiconductor device 3 mounted thereon. Additionally, the assembly comprises a resin body 61 in which an auxiliary terminal (structure) 4 is partially embedded. The auxiliary terminal structure 4 projects out of the right side of the resin body 61, wherein this projecting part constitutes a terminal region for the external electrical connection of the auxiliary terminal 4.

A further exposed part of the auxiliary terminal structure 4 comprises a through hole with means 41 for a threaded connection, namely an inner thread. The through hole is located vertically above the measurement surface 30 of the power semiconductor device 3.

Below the through hole, a sensor element 1 is placed on the measurement surface 1. The sensor element 1 is, for example, again fixed to and electrically connected to the measurement surface 30 by means of a material-locking connection.

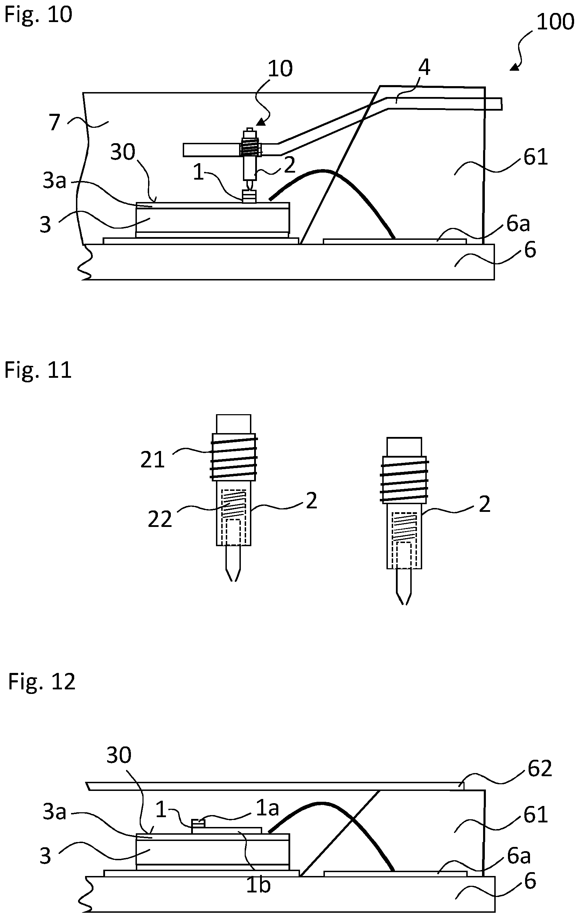

In figure 10, a further exemplary embodiment of the electronic device 100 is shown. Again, the electronic device 100 is a power semiconductor module 100. This power semiconductor module 100 has been obtained by screwing the contact element 2 of figure 8 into the through hole of the auxiliary terminal structure 7 of figure 9. Thereby, the tip element of the contact element 2 has come into mechanical and electrical contact with the sensor element 1, namely its top electrode and a dry contact has formed.

The screwing has also compressed the spring 22 of the contact element 2 so that the contact element 2 has been biased. Consequently, the tip element of the contact element 2 is pressed against the measurement surface 30 by the biased contact element 2 and in this way a reliable dry connection and a reliable dry electrical contact is formed between the contact element 2 and the sensor element 1.

Due to the threaded connection between the auxiliary terminal structure 4 and the contact element 2, the contact element 2 is fixed in position and fixed in its biased state. Afterwards, a casting material 7, e.g. in the form of a gel, has been applied. The casting material 7 and the resin body 61 together form the housing body of the power semiconductor module 100. The sensor element 1 can be read out with help of the contact element 2 and the auxiliary terminal 4 as well as with the help of a further terminal (e.g. a main terminal electrically connected with the measurement surface of the chip), for example.

In the position of figure 11, two contact elements 2 each realized as a press contact pin are provided.

Figure 12 shows a position in which an assembly of several members 3, 6, 61, 62 is provided. Here, one member 62 is a circuit board, e.g. a PCB, mounted on the resin body 61 and laterally overlapping with the power semiconductor device 3.

The member 62 may be a control board and may comprise control devices. A sensor element 1 is placed of the power semiconductor device 3 and is, e.g., fixedly connected thereto.

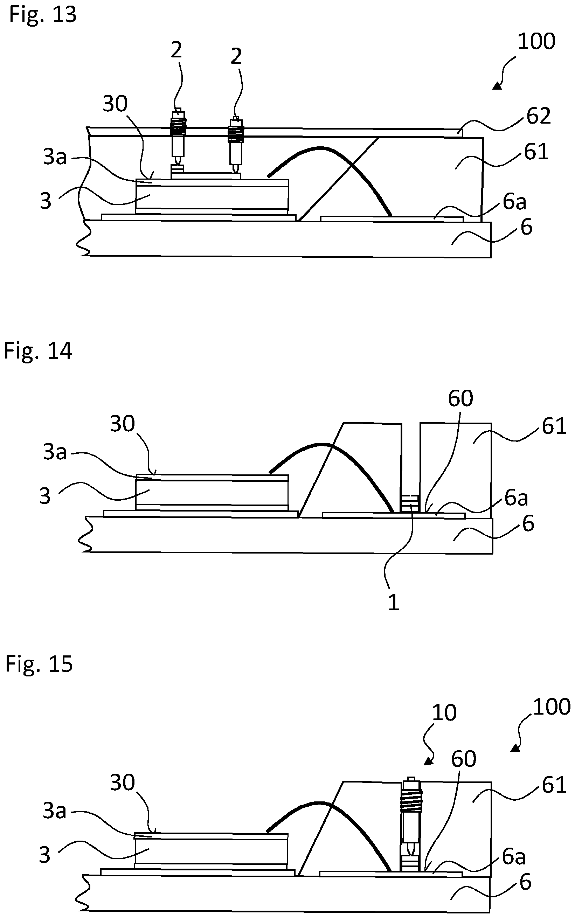

In figure 13, the two contact elements 2 of figure 11 are mounted by screwing them through threaded holes in the circuit board 62 so that they come into electrical contact with the sensor element 1. Due to the screwing, the contact elements 2 are mechanically fixed to the circuit board 62 and at the same time are mechanically biased so that the tip elements of the contact elements 2 are pressed against the sensor element 1 and reliable dry electrical contacts are formed.

In figure 13, one contact element 2 is in dry electrical contact to the top electrode 1a of the sensor element 1 and the other contact element 2 is in dry electrical contact to the bottom electrode 1b. Thus, the sensor element 1 can be read out with the help of both contact elements 2.

In order to enable both the top 1a and the bottom 1b electrode to be contacted with the contact elements 2 from the top side, as shown in figure 13, the bottom electrode 1b projects beyond the top electrode 1a in lateral direction.

Alternatively, the sensor element 1 could comprise two electrodes 1a and 1b at its top side so that also in this case the sensor element 1 could be contacted with the two contact elements 2 from the top side.

Figure 13 shows a further exemplary embodiment of an electronic device 100 in the form of a power semiconductor module 100. In this case, both contact elements 2 of the sensor unit 10 project out of the circuit board in vertical direction so that terminal regions of both contact elements 2 are exposed at the top side of the power semiconductor module 100. These terminal regions of the two contact elements 2 can be electrically connected for read-out of the sensor element 1.

Figure 14 shows a position in which an assembly of a substrate 6, a power semiconductor device 3 and a resin body 61 is provided. A hole is formed in the resin body 61 above the top metallization 6a. In this case, the top metallization 6a forms a measurement surface 60 at which a physical quantity, for example the temperature, shall be measured. The sensor element 1 is placed on this top side in the region of the hole in the resin body 61.

In the position of figure 15, the contact element 2 of figure 8 is mounted by screwing it into the hole in the resin body 61 so that the contact element 2 comes into contact with the sensor element 1. For enabling the screwing, the hole in the resin body 61 may comprise an inner thread. Alternatively, a nut with an inner thread may be embedded in the resin body (not shown).

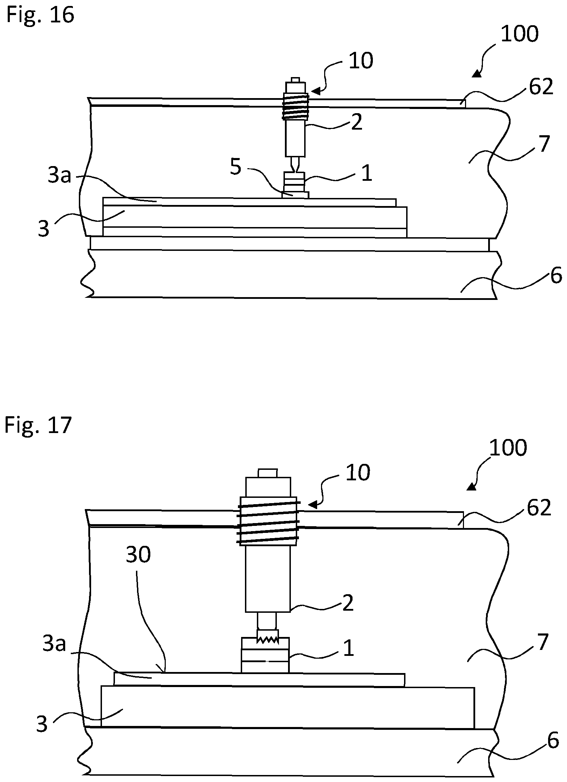

Figure 16 shows an exemplary embodiment of the electronic device 100 being a power semiconductor module 100. In this case, a thermally conductive material 5, e.g. in the form of a paste filled with electrically and/or thermally conductive particles, like metal particles, or a flexible material sheet is arranged between the sensor element 1 and the measurement surface 30. A dry electrical contact may be formed between the material 5 and the sensor element 1 as well as between the material 5 and the measurement surface 30. The sensor element 1 may be fixed to the contact element 2 by means of a material-locking connection.

In the case of figure 16, the thermally conductive material 5 is also electrically conductive in order to establish an electrical contact between the top electrode 3a and the sensor element 1. If such a thermally conductive material 5 would be used in the exemplary embodiment of figure 13, the material 5 could be electrically isolating, for example.

In the exemplary embodiment of the electronic device 100 of figure 17, the tip element of the contact element 2 comprises a roughening with a plurality of protrusions and recesses. The average roughness of this roughening is, for example, at least 1.6 µm. When the contact element 2 is pressed against the top electrode of the sensor element 1 by means of the biased contact element 2, the protrusions may imprint into the top electrode and thereby improve the dry connection, e.g. by penetrating and/or locally destroying an occurring oxide layer. For this purpose, the top electrode may be comparably soft compared to the material of the roughened surface.

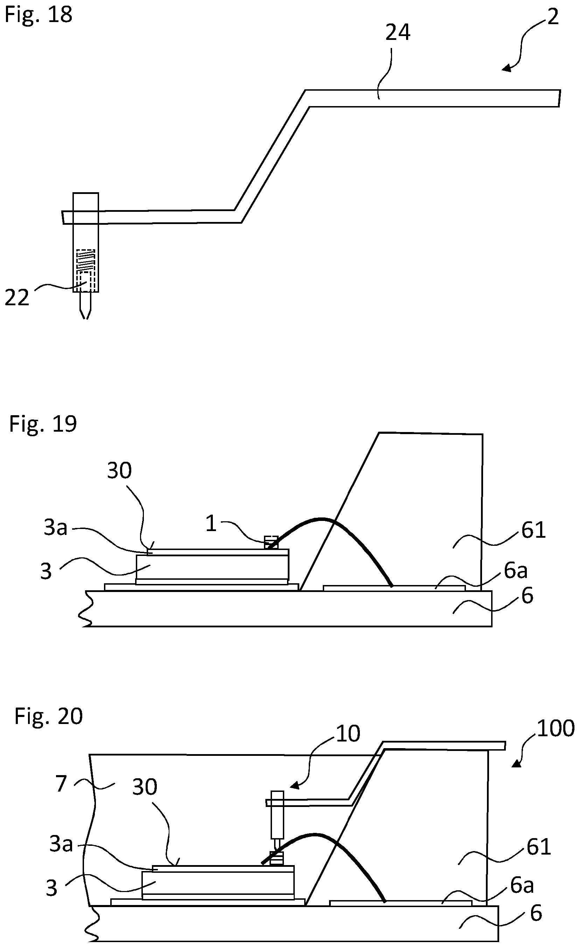

Figure 18 shows a position in which a further exemplary embodiment of the contact element 2 for an electronic device is provided. In this case, the contact element 2 comprises a press contact pin as described before and additionally a terminal structure 24 which is mechanically and electrically connected to the press contact pin. This connection may be established in different ways, for example by screwing, soldering, gluing, sintering, welding etc. The terminal structure 24 is a sheet-like element and may be formed of metal, e.g. Cu or Cu alloy.

In the position of figure 19, an assembly of different members for an electronic device 100 is again provided comprising a substrate 6, a power semiconductor device 3 and a resin body 61. The sensor element 1 is placed on and fixed to the measurement surface 30 formed by the top electrode 3a of the power semiconductor device 3.

Figure 20 shows an exemplary embodiment of the electronic device 100 in the form of a power semiconductor module 100 which is produced, inter alia, by mounting the contact element 2 of figure 18 onto the assembly of figure 19. The auxiliary terminal structure 24 is, for example, glued to the resin body 61 so that the press contact pin is maintained in its biased state. In figure 20, the power semiconductor device 3 and part of the contact element 2 are embedded into a casting 7 in the form of a gel, for example. The terminal structure 24 constitutes an auxiliary terminal of the power semiconductor module 100.

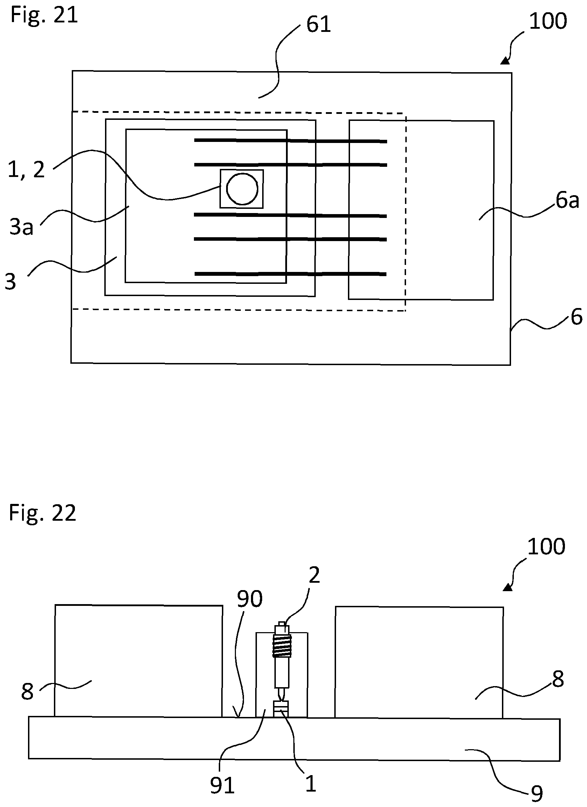

Figure 21 shows an exemplary embodiment of the electronic device 100 in top view onto the measurement surface 30. As can be seen here, the sensor element 1 is placed on the measurement surface 30 laterally between two adjacent bond wires, wherein the two adjacent bond wires are both electrically and mechanically connected to the top electrode 3a of the power semiconductor device 3.

Figure 22 shows an exemplary embodiment of an electronic device 100 in the form of an assembly of two power semiconductor modules 8 mounted on a cooler 9. The cooler 9 is configured for cooling the power semiconductor modules 8. For example, the cooler 9 comprises a channel for guiding a cooling liquid through the cooler 9. The cooler 9 is, for example, formed of metal, like Cu or Al. An exposed surface of the cooler 9 is used as a measurement surface 90. A nut 91 with an inner thread is mounted on the measurement surface 90. The sensor element 1 is placed on the measurement surface 90 in the region of the hole in the nut 91. The contact element 2 of figure 8 is screwed into the nut 91 and a dry electrical contact is formed between the sensor element 1 and the contact element 2. The contact element 2 is fixed to the nut 91 in its biased state by means of the threaded connection.

Instead of the cooler 9 forming the measurement surface, also a baseplate of a power semiconductor module may form the measurement surface.

### Reference Signs

- 1: sensor element
- 1a: top electrode
- 1b: bottom electrode
- 2: contact element
- 3: power semiconductor device
- 3a: top electrode
- 4: auxiliary terminal (structure)
- 5: thermally conductive material
- 6: substrate
- 6a: top metallization
- 7: casting/gel
- 8: power semiconductor module
- 9: cooler
- 10: sensor unit for an electronic device
- 21: means for threaded connections
- 22: spring
- 24: auxiliary terminal structure
- 30: measurement surface
- 41: means for threaded connection
- 60: measurement surface
- 61: resin/resin body/housing frame
- 62: circuit board
- 90: measurement surface
- 91: nut
- 100: electronic device

## Claims

1. Electronic device (100) comprising
- a sensor element (1) for measuring a physical quantity in the electronic device (100),
- a contact element (2) configured to be mechanically biased,
- a measurement surface (30, 60, 90) at which the physical quantity is to be measured with the help of the sensor element (1), wherein
- the sensor element (1) is placed on the measurement surface (30),
- the contact element (2) is electrically connected to the sensor element (1),
- at least one of the connection between the sensor element (1) and the contact element (2) and the connection between the sensor element (1) and the measurement surface (30, 60, 90) is a non-material-locking connection,
- the contact element (2) is mechanically biased in order to prevent loosening of the at least one non-material-locking connection
**characterized in that**
- the sensor element (1) is connected to the measurement surface (30, 40, 50) by means of a material-locking connection, and
- a non-material-locking electrical contact is formed between the contact element (2) and the sensor element (1).

2. Electronic device (100) according to claim 1, wherein
- the sensor element (1) is a temperature sensor.

3. Electronic device (100) according to claim 1 or 2, wherein
- the contact element (2) comprises a spring contact or a press contact pin.

4. Electronic device (100) according to any one of the preceding claims, wherein
- a terminal region for externally electrically connecting the sensor element (1) via the contact element (2) overlaps with the sensor element (1) in at least one lateral direction.

5. Electronic device (100) according to any of the preceding claims, wherein
- a terminal region for externally electrically connecting the sensor element (1) via the contact element (2) is offset of the sensor element (1) in at least one lateral direction.

6. Electronic device (100) according to any of the preceding claims, wherein
- the sensor element (1) comprises a top electrode (1a) at a top side of the sensor element (1) and a bottom electrode (1b) at a bottom side of the sensor element (1) opposite to the top side,
- the contact element (2) is connected to the top electrode (1a) of the sensor element (1),
- the measurement surface (30, 60, 90) is connected to the bottom electrode (1b) of the sensor element (1).

7. Electronic device (100) according to any one of the preceding claims, further comprising
- a power semiconductor device (3), wherein
- the sensor element (1) is placed on the power semiconductor device (3).

8. Electronic device (100) according to claim 7, wherein
- the measurement surface (30) is formed by a top electrode (3a) of the power semiconductor device (3).

9. Electronic device (100) according to any one of the preceding claims, wherein
- the contact element (2) is electrically and mechanically connected to an auxiliary terminal (4) of the electronic device (100) by means of a threaded connection,
- the auxiliary terminal (4) is externally electrically connectable.

10. Method for producing an electronic device (100) comprising,
- providing a sensor element (1),
- providing a contact element (2) configured to be mechanically biased,
- providing a member (3, 6, 9) for an electronic device (100) having a measurement surface (30, 60, 90) at which a physical quantity of the electronic device (100) is to be measured with the help of the sensor element (1),
- placing the sensor element (1) onto the measurement surface (30, 60, 90),
- electrically connecting the contact element (2) and the sensor element (1), wherein
- at least one of the connection between the contact element (2) and the sensor element (1) and the connection between the sensor element (1) and the measurement surface (30, 60, 90) is a non-material-locking connection,
- mechanically biasing the contact element (2),
- fixing at least a portion of the mechanically biased contact element (2) with respect to the member (3, 6, 9) so that the contact element (2) remains in the mechanically biased state in order to prevent loosening of the at least one non-material-locking connection, wherein
- the sensor element (1) is connected to the measurement surface (30, 40, 50) by means of a material-locking connection,
- a non-material-locking electrical contact is formed between the contact element (2) and the sensor element (1).

11. Method according to claim 10, wherein
- a portion of the contact element (2) is fixed with respect to the member (3, 6, 9) by means of a threaded connection.

## Patentansprüche

1. Elektronische Vorrichtung (100), die Folgendes umfasst:
- ein Sensorelement (1) zum Messen einer physikalischen Größe in der elektronischen Vorrichtung (100),
- ein Kontaktelement (2), das dazu ausgebildet ist, mechanisch vorgespannt zu werden,
- eine Messfläche (30, 60, 90), an der die physikalische Größe mithilfe des Sensorelements (1) gemessen werden soll, wobei
- das Sensorelement (1) auf der Messfläche (30) platziert ist,
- das Kontaktelement (2) mit dem Sensorelement (1) elektrisch verbunden ist,
- mindestens eine der Verbindungen zwischen dem Sensorelement (1) und dem Kontaktelement (2) und zwischen dem Sensorelement (1) und der Messfläche (30, 60, 90) eine nicht stoffschlüssige Verbindung ist,
- das Kontaktelement (2) mechanisch vorgespannt ist, um ein Lösen der mindestens einen nicht stoffschlüssigen Verbindung zu verhindern, **dadurch gekennzeichnet, dass**
- das Sensorelement (1) mittels einer stoffschlüssigen Verbindung mit der Messfläche (30, 40, 50) verbunden ist und
- ein nicht stoffschlüssiger elektrischer Kontakt zwischen dem Kontaktelement (2) und dem Sensorelement (1) gebildet ist.

2. Elektronische Vorrichtung (100) nach Anspruch 1, wobei
- das Sensorelement (1) ein Temperatursensor ist.

3. Elektronische Vorrichtung (100) nach Anspruch 1 oder 2, wobei
- das Kontaktelement (2) einen Federkontakt oder einen Druckkontaktstift umfasst.

4. Elektronische Vorrichtung (100) nach einem der vorhergehenden Ansprüche, wobei
- ein Anschlussbereich zur externen elektrischen Verbindung des Sensorelements (1) über das Kontaktelement (2) in mindestens einer lateralen Richtung mit dem Sensorelement (1) überlappt.

5. Elektronische Vorrichtung (100) nach einem der vorhergehenden Ansprüche, wobei
- ein Anschlussbereich zur externen elektrischen Verbindung des Sensorelements (1) über das Kontaktelement (2) in mindestens einer lateralen Richtung von dem Sensorelement (1) versetzt ist.

6. Elektronische Vorrichtung (100) nach einem der vorhergehenden Ansprüche, wobei
- das Sensorelement (1) eine obere Elektrode (1a) an einer Oberseite des Sensorelements (1) und eine untere Elektrode (1b) an einer Unterseite des Sensorelements (1) gegenüber der Oberseite umfasst,
- das Kontaktelement (2) mit der oberen Elektrode (1a) des Sensorelements (1) verbunden ist,
- die Messfläche (30, 60, 90) mit der unteren Elektrode (1b) des Sensorelements (1) verbunden ist.

7. Elektronische Vorrichtung (100) nach einem der vorhergehenden Ansprüche, die ferner Folgendes umfasst:
- eine Leistungshalbleitervorrichtung (3), wobei
- das Sensorelement (1) auf der Leistungshalbleitervorrichtung (3) platziert ist.

8. Elektronische Vorrichtung (100) nach Anspruch 7, wobei
- die Messfläche (30) durch eine obere Elektrode (3a) der Leistungshalbleitervorrichtung (3) gebildet wird.

9. Elektronische Vorrichtung (100) nach einem der vorhergehenden Ansprüche, wobei
- das Kontaktelement (2) mittels einer Gewindeverbindung elektrisch und mechanisch mit einem zusätzlichen Anschluss (4) der elektronischen Vorrichtung (100) verbunden ist,
- der zusätzliche Anschluss (4) extern elektrisch verbindbar ist.

10. Verfahren zur Herstellung einer elektronischen Vorrichtung (100), das Folgendes umfasst:
- Bereitstellen eines Sensorelements (1),
- Bereitstellen eines Kontaktelements (2), das dazu ausgebildet ist, mechanisch vorgespannt zu werden,
- Bereitstellen eines Glieds (3, 6, 9) für eine elektronische Vorrichtung (100) mit einer Messfläche (30, 60, 90), an der eine physikalische Größe der elektronischen Vorrichtung (100) mithilfe des Sensorelements (1) gemessen werden soll,
- Platzieren des Sensorelements (1) auf der Messfläche (30, 60, 90),
- elektrisches Verbinden des Kontaktelements (2) und des Sensorelements (1), wobei
- die Verbindung zwischen dem Kontaktelement (1) und dem Sensorelement (2) und/oder die Verbindung zwischen dem Sensorelement (1) und der Messfläche (30, 60, 90) eine nicht stoffschlüssige Verbindung ist,
- mechanisches Vorspannen des Kontaktelements (2),
- Fixieren mindestens eines Teils des mechanisch vorgespannten Kontaktelements (2) in Bezug auf das Glied (3, 6, 9), sodass das Kontaktelement (2) in dem mechanisch vorgespannten Zustand verbleibt, um ein Lösen der mindestens einen nicht stoffschlüssigen Verbindung zu verhindern, wobei
- das Sensorelement (1) mittels einer stoffschlüssigen Verbindung mit der Messfläche (30, 40, 50) verbunden ist,
- ein nicht stoffschlüssiger elektrischer Kontakt zwischen dem Kontaktelement (2) und dem Sensorelement (1) gebildet ist.

11. Verfahren nach Anspruch 10, wobei
- ein Teil des Kontaktelements (2) mittels einer Gewindeverbindung in Bezug auf das Glied (3, 6, 9) fixiert ist.

## Revendications

1. Dispositif électronique (100) comprenant
- un élément capteur (1) pour mesurer une grandeur physique dans l'appareil électronique (100),
- un élément de contact (2) configuré pour être mécaniquement précontraint,
- une surface de mesure (30, 60, 90) sur laquelle la grandeur physique doit être mesurée à l'aide de l'élément capteur (1),
- l'élément capteur (1) étant placé sur la surface de mesure (30),
- l'élément de contact (2) étant relié électriquement à l'élément capteur (1),
- au moins une de la liaison entre l'élément capteur (1) et l'élément de contact (2) et la liaison entre l'élément capteur (1) et la surface de mesure (30, 60, 90) étant une liaison sans blocage par matière,
- l'élément de contact (2) étant mécaniquement précontraint afin d'empêcher le desserrage de l'au moins une liaison sans blocage par matière, **caractérisé en ce que**
- l'élément capteur (1) est relié à la surface de mesure (30, 40, 50) par une liaison à blocage par matière, et
- un contact électrique sans blocage par matière est formé entre l'élément de contact (2) et l'élément capteur (1).

2. Dispositif électronique (100) selon la revendication 1, dans lequel
- l'élément capteur (1) est un capteur de température.

3. Dispositif électronique (100) selon la revendication 1 ou 2, dans lequel
- l'élément de contact (2) comprend un contact à ressort ou une broche de contact à pression.

4. Dispositif électronique (100) selon l'une quelconque des revendications précédentes, dans lequel
- une zone de borne destinée à la liaison électrique externe de l'élément capteur (1) via l'élément de contact (2) chevauche l'élément capteur (1) dans au moins une direction latérale.

5. Dispositif électronique (100) selon l'une quelconque des revendications précédentes, dans lequel
- une zone de borne destinée à la liaison électrique externe de l'élément capteur (1) via l'élément de contact (2) est décalée par rapport à l'élément capteur (1) dans au moins une direction latérale.

6. Dispositif électronique (100) selon l'une quelconque des revendications précédentes, dans lequel
- l'élément capteur (1) comprend une électrode supérieure (1a) sur un côté supérieur de l'élément capteur (1) et une électrode inférieure (1b) sur un côté inférieur de l'élément capteur (1) opposé au côté supérieur,
- l'élément de contact (2) est relié à l'électrode supérieure (1a) de l'élément capteur (1),
- la surface de mesure (30, 60, 90) est reliée à l'électrode inférieure (1b) de l'élément capteur (1).

7. Dispositif électronique (100) selon l'une quelconque des revendications précédentes, comprenant en outre
- un dispositif à semi-conducteur de puissance (3), dans lequel
- l'élément capteur (1) est placé sur le dispositif à semi-conducteur de puissance (3).

8. Dispositif électronique (100) selon la revendication 7, dans lequel
- la surface de mesure (30) est formée par une électrode supérieure (3a) du dispositif à semi-conducteur de puissance (3).

9. Dispositif électronique (100) selon l'une quelconque des revendications précédentes, dans lequel
- l'élément de contact (2) est relié électriquement et mécaniquement à une borne auxiliaire (4) du dispositif électronique (100) au moyen d'une liaison filetée,
- la borne auxiliaire (4) peut être connectée électriquement à l'extérieur.

10. Procédé de production d'un dispositif électronique (100) comprenant,
- la fourniture d'un élément capteur (1),
- la fourniture d'un élément de contact (2) configuré pour être précontraint mécaniquement,
- la fourniture d'une pièce (3, 6, 9) pour un dispositif électronique (100) ayant une surface de mesure (30, 60, 90) sur laquelle une grandeur physique du dispositif électronique (100) doit être mesurée à l'aide de l'élément capteur (1),
- le placement de l'élément capteur (1) sur la surface de mesure (30, 60, 90),
- la connexion électrique de l'élément de contact (2) et de l'élément capteur (1),
- au moins une de la liaison entre l'élément de contact (2) et l'élément capteur (1) et la liaison entre l'élément capteur (1) et la surface de mesure (30, 60, 90) étant une liaison sans blocage par matière,
- la précontrainte mécanique de l'élément de contact (2),
- la fixation d'au moins une partie de l'élément de contact (2) mécaniquement précontraint par rapport à la pièce (3, 6, 9) de sorte que l'élément de contact (2) reste dans l'état mécaniquement précontraint afin d'empêcher le desserrage de l'au moins une liaison sans blocage par matière,
- l'élément capteur (1) étant relié à la surface de mesure (30, 40, 50) par une liaison à blocage par matière,
- un contact électrique sans blocage par matière est formé entre l'élément de contact (2) et l'élément capteur (1).

11. Procédé selon la revendication 10, dans lequel
- une partie de l'élément de contact (2) est fixée par rapport à la pièce (3, 6, 9) au moyen d'une liaison filetée.
